# EUROPEAN PATENT APPLICATION

(11) **EP 4 620 729 A2**
(43) Date of publication of application: **24.09.2025**
(21) Application number: 25163926.6
(22) Date of filing: 14.03.2025
(51) Int. Cl.: B60L 58/26

(54) **HEAT MANAGEMENT SYSTEM**

(30) Priority: 21.03.2024 JP 2024044773
(71) Applicant: TOYOTA JIDOSHA KABUSHIKI KAISHA, Toyota-shi, Aichi-ken, 471-8571 (JP)
(72) Inventor: MIYOSHI, Yuji, Aichi-ken, 471-8571 (JP); KAWABE, Takayuki, Aichi-ken, 471-8571 (JP); IMAI, Sohichi, Aichi-ken, 471-8571 (JP)
(74) Representative: D Young & Co LLP

(57) **Abstract**

A heat management system includes: a first flow channel (130a; 270a; 311a; 312a) through which a heat medium flows; a second flow channel (170a; 260a; 313) through which the heat medium flows; a reserve tank (175; 265; 313b) that is provided on the second flow channel (170a; 260a; 313); a pump (131; 171; 261; 311c; 312b) that causes the heat medium to circulate; and a switching device (180; 280; 330). When the charging of an electric apparatus is ended in a state where the first flow channel (130a; 270a; 311a; 312a) and the second flow channel (170a; 260a; 313) are disconnected, the heat management system executes an air removal process for the first flow channel (130a; 270a; 311a; 312a) and the second flow channel (170a; 260a; 313), after the end of the above charging, by connecting the first flow channel (130a; 270a; 311a; 312a) and the second flow channel (170a; 260a; 313) by the switching device (180; 280; 330) and driving the pump (131; 171; 261; 311c; 312b).

## Description

### BACKGROUND OF THE INVENTION

### 1. Field of the Invention

The present disclosure relates to a heat management system.

### 2. Description of Related Art

Japanese Unexamined Patent Application Publication No 2023-063735 (JP 2023-063735 A) discloses a temperature control system including a coolant circuit provided with a channel to which a PCU is connected, a channel to which a battery is connected, a reserve tank, and a five-way valve that switches the flowing channel of coolant.

### SUMMARY OF THE INVENTION

Although not clearly described in JP 2023-063735 A, a circuit in which the channel (first flow channel) to which the PCU is connected or the channel (second flow channel) to which the battery is connected and the reserve tank are not connected is sometimes formed temporarily, by the control of the state of the five-way valve. In this case, there is a risk that an air bubble is mixed (remains) in the channel that is not connected with the reserve tank.

The present disclosure provides a heat management system that can restrain the air bubble from being mixed (remaining) in the first flow channel and the second flow channel using the reserve tank.

A heat management system according to an aspect of the present disclosure is a heat management system provided in an electric apparatus that is able to be charged, the heat management system including: a first flow channel through which a heat medium flows; a second flow channel through which the heat medium flows and on which a reserve tank is provided; a switching device that is able to switch a connection state between the first flow channel and the second flow channel; and a pump that causes the heat medium to circulate through each of the first flow channel and the second flow channel in a state where the first flow channel and the second flow channel are connected. In the heat management system, when charging of the electric apparatus is ended in a state where the first flow channel and the second flow channel are disconnected, an air removal process for the first flow channel and the second flow channel is executed after the end of the charging, by connecting the first flow channel and the second flow channel by the switching device and driving the pump.

In the heat management system according to the aspect of the present disclosure, as described above, when charging of the electric apparatus is ended in the state where the first flow channel and the second flow channel are disconnected, the air removal process for the first flow channel and the second flow channel is executed. Thereby, after the end of the charging of the electric apparatus, the air removal is performed in each of the first flow channel and the second flow channel. As a result, it is possible to restrain the air bubble from being mixed (remaining) in each of the first flow channel and the second flow channel, using the reserve tank.

Further, since the air removal process is executed after the end of the charging, the air removal can be performed when the amount of the heat generation in the electric apparatus is relatively small, compared to a case where the air removal is performed at the time of the charging. As a result, it is possible to restrain the air bubble from becoming large due to the heat generation. Thereby, it is possible to easily reduce the mixed amount (remaining amount) of the air bubble in the first flow channel and the second flow channel.

In the heat management system according to the above aspect, when the air removal process has been continued for a first time or more, the air removal process may be ended. In this configuration, it is possible to prevent the air removal process from being continued for the first time or more. As a result, it is possible to relatively shorten the time required to execute the air removal process once.

The heat management system according to the above aspect may further include: a first electric storage device that performs heat exchange with the heat medium that flows through one of the first flow channel and the second flow channel; and a first drive device that performs heat exchange with the heat medium that flows through the other of the first flow channel and the second flow channel, the first drive device being able to generate drive power. In this configuration, it is possible to efficiently cool each of the first electric storage device and the first drive device by the heat medium after the end of the charging, by restraining the air bubble from being mixed (remaining) in each of the first flow channel and the second flow channel after the end of the charging.

In this case, the heat management system may further include a bypass channel that bypasses at least a portion that is of the first flow channel and where the heat exchange between the first electric storage device and the heat medium is performed. When the temperature of the heat medium that flows through the second flow channel is a predetermined temperature or higher at a time of the execution of the air removal process, the heat medium may be avoided from flowing through the portion and may flow through the bypass channel. In this configuration, it is possible to perform the air removal process while restraining the temperature of the first electric storage device from being increased by the heat medium that flows through the second flow channel.

In the heat management system according to the above aspect, when an accumulated time for which the pump has been driven in the state where the first flow channel and the second flow channel are connected has exceeded a second time, the air removal process may be avoided from being executed. In this configuration, it is possible to restrain the air removal process from being excessively performed in the electric apparatus.

In this case, the accumulated time may be the total value of a first accumulated time and a second accumulated time, the first accumulated time being an accumulated time for which the air removal process has been executed, the second accumulated time being an accumulated time for which the pump has been driven in the state where the first flow channel and the second flow channel are connected, at a timing other than a timing after the end of the charging. In this configuration, it is possible to perform a control to restrict the execution of the air removal process based on a time for which the air removal has been actually performed in the first flow channel and the second flow channel, unlike a case where only the first accumulated time is considered as the above accumulated time.

In the heat management system according to the above aspect, when the heat medium that flows through the electric apparatus has been replaced in a state where the air removal process is not executed, a state where the air removal process is able to be executed may be caused. When the heat medium is replaced, the air bubble is easily mixed. Accordingly, in the above configuration, the air bubble mixed by the replacement of the heat medium can be removed by the air removal process.

In the heat management system according to the above aspect, the switching device may include a five-way valve or an eight-way valve. In this configuration, the connection state between the first flow channel and the second flow channel can be easily switched by the five-way valve or the eight-way valve.

The heat management system according to the above aspect may include: a radiator; a second electric storage device; and a second drive device that is able to generate drive power. The radiator may be provided on the second flow channel. At least one of the second electric storage device and the second drive device may perform heat exchange with the heat medium that flows through the first flow channel. In this configuration, it is possible to perform the air removal for the first flow channel and the second flow channel, while cooling at least one of the second electric storage device and the second drive device using the heat medium cooled by the radiator.

With the present disclosure, it is possible to restrain the air bubble from being mixed (remaining) in the first flow channel and the second flow channel using the reserve tank.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram showing the configuration of an electrified vehicle that is equipped with a heat management system according to an embodiment;
FIG. 2 is a diagram showing an example of the configuration of the heat management system according to the embodiment;
FIG. 3 is a diagram showing an example of the configuration of a heat management circuit according to the embodiment;
FIG. 4 is a diagram showing a first communication pattern of the heat management circuit according to the embodiment;
FIG. 5 is a diagram showing a second communication pattern of the heat management circuit according to the embodiment;
FIG. 6 is a diagram showing a third communication pattern of the heat management circuit according to the embodiment;
FIG. 7 is a first diagram showing a control flow in the heat management system according to the embodiment;
FIG. 8 is a second diagram showing a control flow in the heat management system according to the embodiment;
FIG. 9 is a third diagram showing a control flow in the heat management system according to the embodiment;
FIG. 10 is a fourth diagram showing a control flow in the heat management system according to the embodiment;
FIG. 11 is a diagram showing an example of the configuration of a heat management system according to a first modification of the embodiment;
FIG. 12 is a diagram showing a first communication pattern in the first modification;
FIG. 13 is a diagram showing a second communication pattern in the first modification;
FIG. 14 is a diagram showing a first modified example of the second communication pattern in the first modification;
FIG. 15 is a diagram showing a second modified example of the second communication pattern in the first modification;
FIG. 16 is a diagram showing a first communication pattern of a heat management system according to a second modification of the embodiment;
FIG. 17 is a diagram showing a second communication pattern in the second modification;
FIG. 18 is a diagram showing a first modified example of the second communication pattern in the second modification; and
FIG. 19 is a diagram showing a second modified example of the second communication pattern in the second modification.

### DETAILED DESCRIPTION OF EMBODIMENTS

An embodiment of the present disclosure will be described below in detail with reference to the drawings. In the drawings, identical or corresponding portions are denoted by identical reference characters, and descriptions thereof are not repeated.

As an example, a configuration in which a heat management system according to the present disclosure is equipped in a vehicle will be described below. Preferably, the vehicle should be a vehicle in which a battery for traveling is equipped. For example, the vehicle is a battery electric vehicle (BEV), a hybrid electric vehicle (HEV), a plug-in hybrid electric vehicle (PHEV), or a fuel cell electric vehicle (FCEV). However, the use of the heat management system according to the present disclosure is not limited to the use in the vehicle.

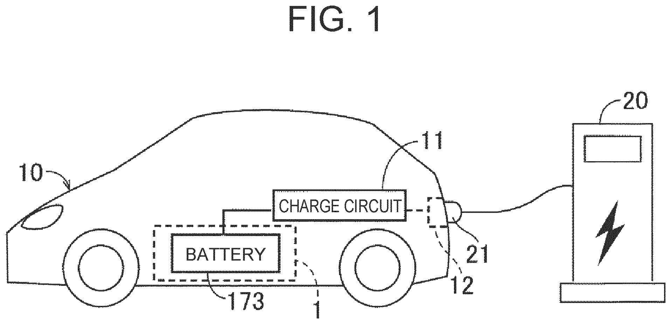

FIG. 1 is a diagram showing an electrified vehicle 10 that is equipped with a heat management system 1 according to the embodiment of the present disclosure. The electrified vehicle 10 can be charged. Specifically, the electrified vehicle 10 includes a battery 173, a charge circuit 11, and an inlet 12. The electrified vehicle 10 and the battery 173 are examples of the "electric apparatus" and "first electric storage device" in the present disclosure, respectively.

The battery 173 stores electric power for driving the electrified vehicle 10. For example, a charge connector 21 of an EVSE 20 is connected to the inlet 12, and thereby, electric power is supplied from the EVSE 20 to the battery 173. The electric power input to the inlet 12 is supplied to the battery 173 through the charge circuit 11. The charge circuit 11 may include a later-described SPU 132.

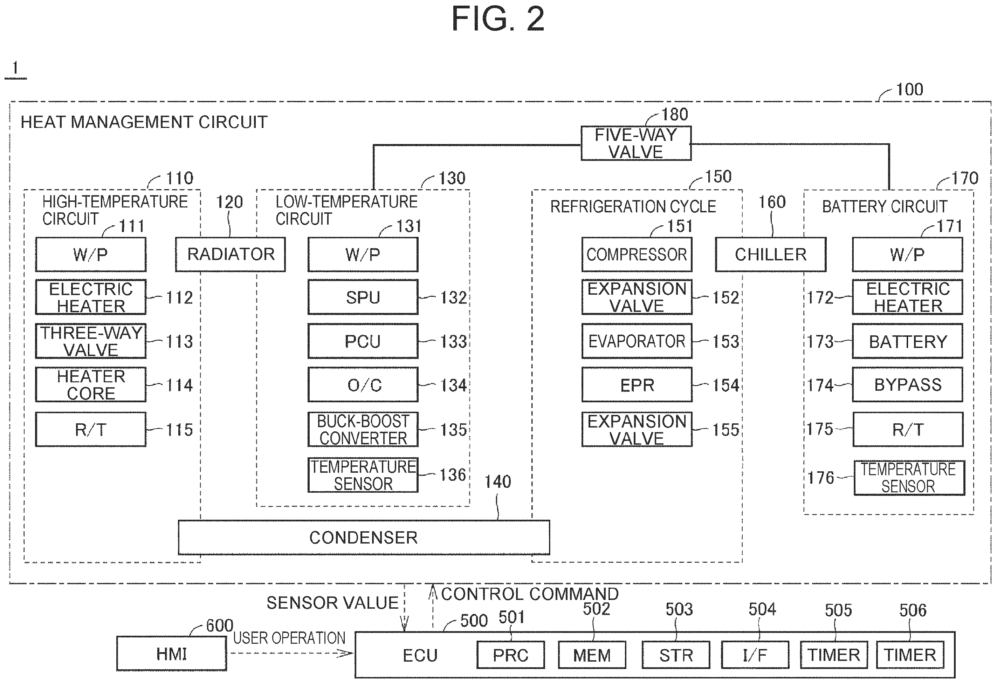

FIG. 2 is a diagram showing an example of the overall configuration of the heat management system 1. The heat management system 1 includes a heat management circuit 100, an electronic control unit (ECU) 500, and a human machine interface (HMI) 600.

The heat management circuit 100 is configured such that a heat medium flows through the heat management circuit 100. The heat management circuit 100 includes a high-temperature circuit 110, a radiator 120, a low-temperature circuit 130, a condenser 140, a refrigeration cycle 150, a chiller 160, a battery circuit 170, and a five-way valve 180. The five-way valve 180 is an example of the "switching device" in the present disclosure.

The high-temperature circuit 110 includes a water pump (W/P) 111, an electric heater 112, a three-way valve 113, a heater core 114, and a reserve tank (R/T) 115. The radiator 120 is connected to both of the high-temperature circuit 110 and the low-temperature circuit 130 (that is, the radiator 120 is shared by both of the high-temperature circuit 110 and the low-temperature circuit 130).

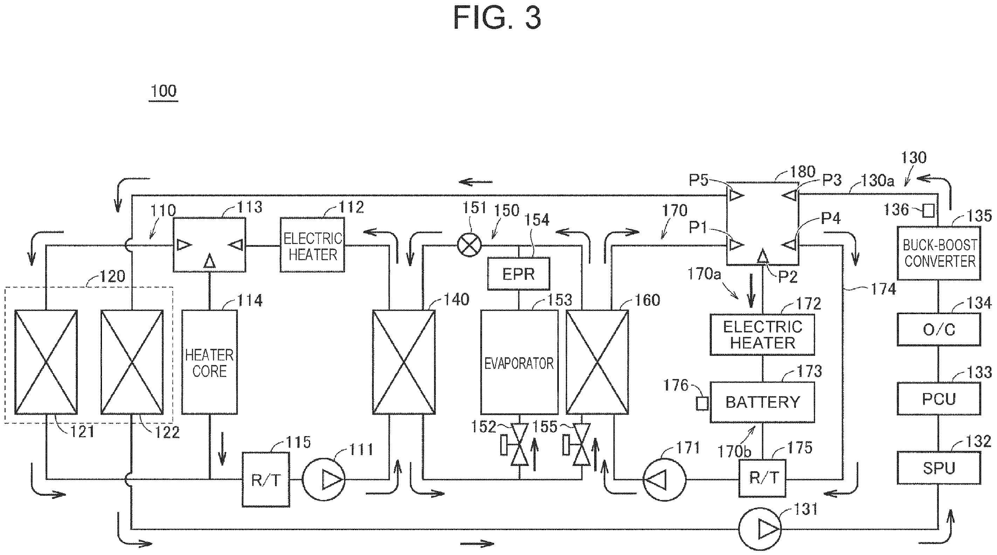

The radiator 120 includes a high-temperature (HT) radiator 121 (see FIG. 3) and a low-temperature (LT) radiator 122 (see FIG. 3).

For example, the low-temperature circuit 130 includes a water pump 131, a smart power unit (SPU) 132, a power control unit (PCU) 133, an oil cooler (O/C) 134, a buck-boost converter 135, and a temperature sensor 136. The water pump 131 is an example of the "pump" in the present disclosure. Further, each of the PCU 133 and the oil cooler 134 is a device that can generate drive power that is supplied to the electrified vehicle 10. Each of the PCU 133 and the oil cooler 134 is an example of the "first drive device" in the present disclosure.

The condenser 140 is connected to both of the high-temperature circuit 110 and the refrigeration cycle 150. The refrigeration cycle 150 includes a compressor 151, an expansion valve 152, an evaporator 153, an evaporative pressure regulator (EPR) 154, and an expansion valve 155. The chiller 160 is connected to both of the refrigeration cycle 150 and the battery circuit 170.

For example, the battery circuit 170 includes a water pump 171, an electric heater 172, a battery 173, a bypass channel 174, a reserve tank 175, and a temperature sensor 176. The five-way valve 180 is connected to the low-temperature circuit 130 and the battery circuit 170. The configuration of the heat management circuit 100 will be described in detail with FIG. 3. The water pump 171 is an example of the "pump" in the present disclosure.

The ECU 500 controls the heat management circuit 100. The ECU 500 includes a processor 501, a memory 502, a storage 503, an interface 504, a timer 505, and a timer 506.

For example, the processor 501 is a central processing unit (CPU) or a micro-processing unit (MPU). The memory 502 is a random access memory (RAM). The storage 503 is a rewritable non-volatile memory such as a hard disk drive (HDD), a solid state drive (SSD), and a flash memory. In the storage 503, a system program including an operating system (OS) and a control program including computer-readable codes that are necessary for control operations are stored. The processor 501 realizes various processes by reading the system program and the control program and expanding and executing the system program and the control program on the memory 502. The interface 504 controls the communication between the ECU 500 and constituent components of the heat management circuit 100. Each of the timer 505 and the timer 506 measures the elapsed time from the execution of a predetermined process. Details of each function of the timer 505 and the timer 506 will be described later.

The ECU 500 generates a control command based on sensor values (for example, temperatures of various spots) acquired from various sensors (not illustrated) included in the heat management circuit 100, a user operation accepted by the HMI 600, and the like, and outputs the generated control command to the heat management circuit 100. The ECU 500 may be divided into a plurality of ECUs according to the function. Further, an example in which the ECU 500 includes one processor 501 is shown in FIG. 2, but the ECU 500 may include a plurality of processors. The same goes for the memory 502 and the storage 503.

In the present specification, the "processor" is not limited to a narrowly defined processor that executes processes by a stored program method. The "processor" may include a hard-wired circuit such as an application specific integrated circuit (ASIC) and a field-programmable gate array (FPGA). Therefore, for the term "processor", processes are previously defined by computer-readable codes and/or a hard-wired circuit. The "processor" can be replaced with a processing circuitry.

The HMI 600 includes a touch panel display, an operation panel, a console, and the like. The HMI 600 accepts the user operation for controlling the heat management system 1. The HMI 600 outputs a signal indicating the user operation, to the ECU 500.

### Configuration of Heat Management Circuit

FIG. 3 is a diagram showing an example of the configuration of the heat management circuit 100 in the embodiment. The heat medium (ordinarily, warm water) that circulates through the high-temperature circuit 110 flows through one or both of a first channel that passes through the water pump 111, the condenser 140, the electric heater 112, the three-way valve 113, the heater core 114, the reserve tank 115, and the water pump 111, and a second channel that passes through the water pump 111, the condenser 140, the electric heater 112, the three-way valve 113, the high-temperature radiator 121, the reserve tank 115, and the water pump 111.

The heat medium (coolant) that circulates through the low-temperature circuit 130 flows through a channel that passes through the water pump 131, the SPU 132, the PCU 133, the oil cooler 134, the buck-boost converter 135, the five-way valve 180, the low-temperature radiator 122, and the water pump 131. This channel includes a flow channel 130a that passes through the water pump 131, the SPU 132, the PCU 133, the oil cooler 134, the buck-boost converter 135, and the five-way valve 180. The flow channel 130a is an example of the "first flow channel" in the present disclosure.

The water pump 131 causes the heat medium to circulate through the low-temperature circuit 130, in accordance with the control command from the ECU 500 (see FIG. 2). The SPU 132 controls the charging and discharging of the battery 173, in accordance with the control command from the ECU 500. The PCU 133 converts direct-current power supplied from the battery 173, into alternating-current power, and supplies the alternating-current power to a motor (not illustrated) built in a transaxle, in accordance with the control command from the ECU 500. The oil cooler 134 causes lubricant for the motor to circulate, using an electrical oil pump (EOP) (not illustrated). The temperature sensor 136 detects the temperature of the heat medium that flows through the flow channel 130a (for example, the upstream side of the buck-boost converter 135). The SPU 132, the PCU 133, the oil cooler 134, and the buck-boost converter 135 are cooled by the heat medium that circulates through the low-temperature circuit 130. The five-way valve 180 switches the channel of the heat medium in the low-temperature circuit 130 and the battery circuit 170, in accordance with the control command from the ECU 500. The low-temperature radiator 122 is disposed near the high-temperature radiator 121, and performs heat exchange with the high-temperature radiator 121.

The heat medium (a gas-phase refrigerant or a liquid-phase refrigerant) that circulates through the refrigeration cycle 150 flows through one or both of the following first channel and second channel. The first channel is a channel that passes through the compressor 151, the condenser 140, the expansion valve 152, the evaporator 153, the EPR 154, and the compressor 151. The second channel is a channel that passes through the compressor 151, the condenser 140, the expansion valve 155, the chiller 160, and the compressor 151.

The heat medium (coolant) that circulates through the battery circuit 170 flows through one or both of a first channel that passes through the water pump 171, the chiller 160, the five-way valve 180, the electric heater 172, the battery 173, the reserve tank 175, and the water pump 171, and a second channel that passes through the water pump 171, the chiller 160, the five-way valve 180, the bypass channel 174, the reserve tank 175, and the water pump 171. The reserve tank 175 is provided at a portion where the first channel and the bypass channel 174 join. The first channel includes a flow channel 170a that passes through the five-way valve 180, the electric heater 172, the battery 173, the reserve tank 175, and the water pump 171. The position where the reserve tank 175 is disposed is not limited to the above example. For example, the reserve tank 175 may be disposed between the five-way valve 180 and the battery 173. The flow channel 170a is an example of the "second flow channel" in the present disclosure.

The water pump 171 causes the heat medium to circulate through the battery circuit 170, in accordance with the control command from the ECU 500. The chiller 160 cools the heat medium that circulates through the battery circuit 170, by the heat exchange between the heat medium that circulates through the refrigeration cycle 150 and the heat medium that circulates through the battery circuit 170. The electric heater 172 heats the heat medium in accordance with the control command from the ECU 500. The battery 173 supplies electric power for traveling, to the motor built in the transaxle. The battery 173 can be heated using the electric heater 172, and can be cooled using the chiller 160. The bypass channel 174 bypasses at least a portion 170b that is of the flow channel 170a and where the heat exchange between the battery 173 and the heat medium is performed. The bypass channel 174 is provided so as to cause the heat medium to bypass the electric heater 172 (a portion (no reference character) that is of the flow channel 170a and where the heat exchange with the electric heater 172 is performed) and the battery 173 (portion 170b). In the case where the heat medium flows through the bypass channel 174, it is possible to restrain the change in the temperature of the heat medium due to the heat absorption or heat release between the heat medium and the battery 173. The reserve tank 175 retains some of the heat medium in the battery circuit 170, and thereby, maintains the pressure and amount of the heat medium in the battery circuit 170. The temperature sensor 176 detects the temperature of the battery 173.

The five-way valve 180 is provided with five ports P1 to P5. The port P1 is an inlet port into which the heat medium flows from the chiller 160. The port P2 is an outlet port from which the heat medium flows toward the electric heater 172 and battery 173 (portion 170b) of the battery circuit 170. The port P3 is an inlet port into which the heat medium flows from the SPU 132, PCU 133, oil cooler 134 and buck-boost converter 135 of the low-temperature circuit 130. The port P4 is an outlet port from which the heat medium flows toward the bypass channel 174 of the battery circuit 170. The port P5 is an outlet port from which the heat medium flows toward the low-temperature radiator 122.

### Communication Pattern

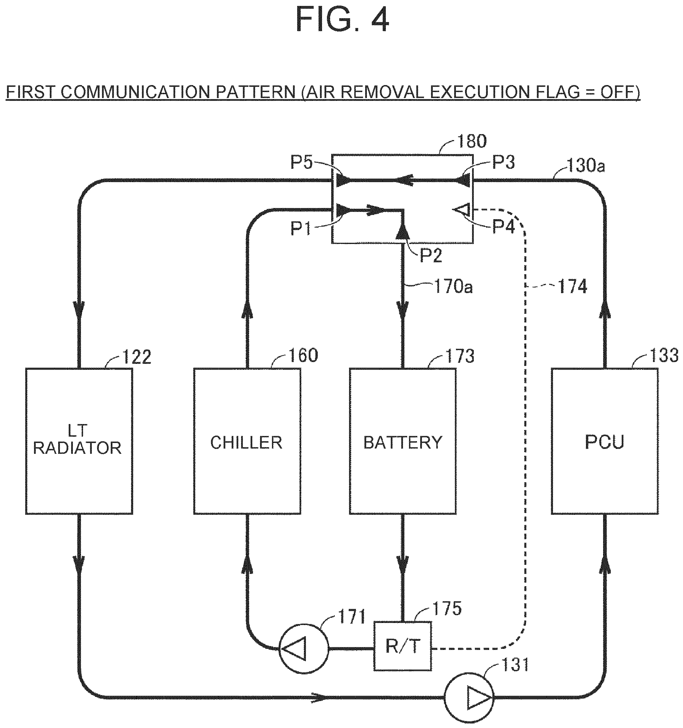

FIG. 4 is a diagram showing an example of a first communication pattern by the five-way valve 180. As shown in FIG. 4, in the first communication pattern, a channel that provides communication between the port P1 and the port P2 and a channel that provides communication between the port P3 and the port P5 are formed in the five-way valve 180. The two channels are independent from each other. Another channel that couples the two channels is not formed. In this case, the low-temperature circuit 130 (flow channel 130a) and the battery circuit 170 (flow channel 170a) are fully independently connected in parallel. The first communication pattern is a circuit pattern that is formed when a later-described "air removal execution flag" is in the OFF-state.

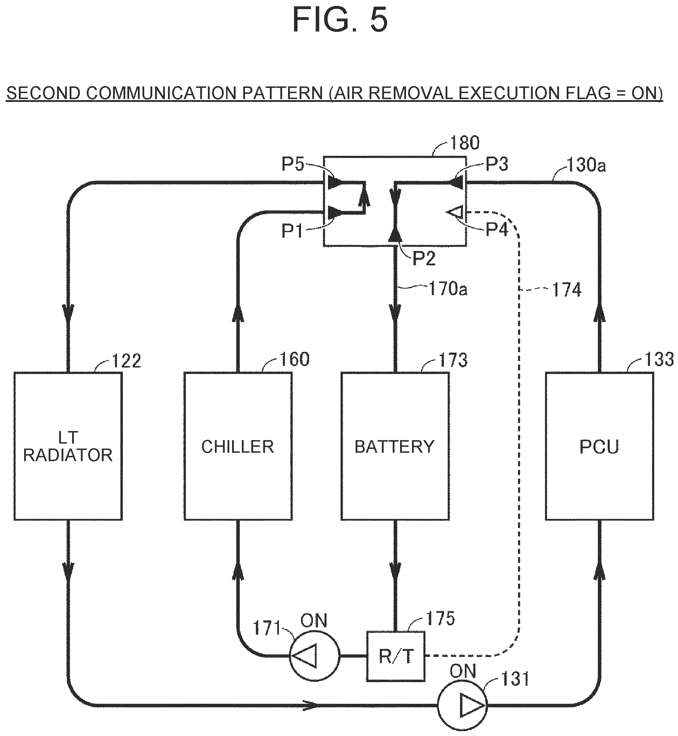

FIG. 5 is a diagram showing an example of a second communication pattern by the five-way valve 180. As shown in FIG. 5, in the second communication pattern, a channel that provides communication between the port P1 and the port P5 and a channel that provides communication between the port P3 and the port P2 are formed in the five-way valve 180. In this case, the low-temperature circuit 130 (flow channel 130a) and the battery circuit 170 (flow channel 170a) are connected in series. As a result, the reserve tank 175, the water pump 171, and the water pump 131 are connected in series. In this state, at least one of the water pump 171 and the water pump 131 is driven, and thereby, air removal is performed by the reserve tank 175 in each of the flow channel 170a and the flow channel 130a. The second communication pattern is a circuit pattern that is formed when the later-described "air removal execution flag" is in the ON-state and a later-described predetermined condition is satisfied. In the embodiment, each of the water pump 171 and the water pump 131 is driven in the second communication pattern. Only one of the water pump 171 and the water pump 131 may be driven.

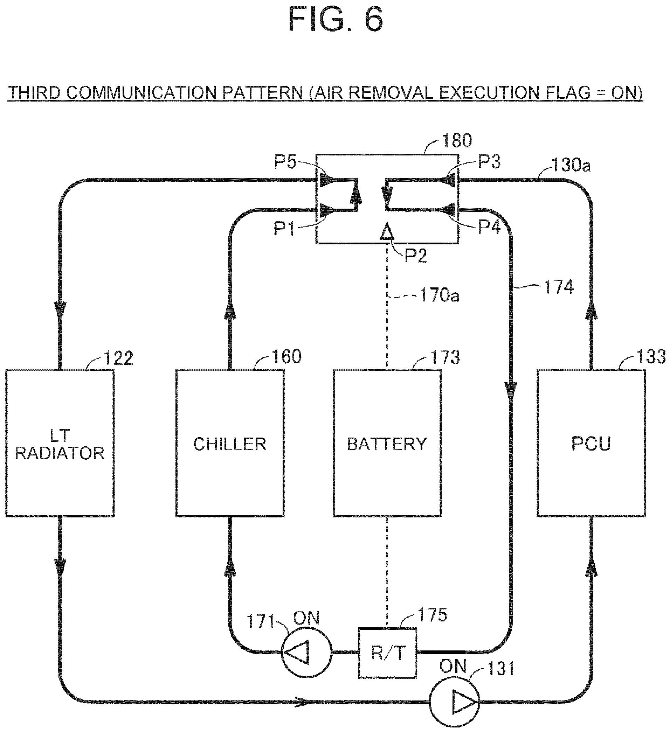

FIG. 6 is a diagram showing an example of a third communication pattern by the five-way valve 180. As shown in FIG. 6, in the third communication pattern, a channel that provides communication between the port P1 and the port P5 and a channel that provides communication between the port P3 and the port P4 are formed in the five-way valve 180. In this case, the reserve tank 175, the water pump 171, and the water pump 131 are connected in series, and the heat exchange between the heat medium and the battery 173 is not performed. The third communication pattern is a circuit pattern that is formed when the later-described "air removal execution flag" is in the ON-state and the later-described predetermined condition is satisfied. In this case, each of the water pump 171 and the water pump 131 is driven. Only one of the water pump 171 and the water pump 131 may be driven.

The first to third communication patterns by the five-way valve 180 are not limited to the examples shown in FIG. 4 to FIG. 6, respectively.

As described above, a circuit (for example, the first communication pattern) in which the flow channel 130a to which the PCU 133 is connected and the reserve tank 175 are not connected is sometimes formed temporarily. In this case, in conventional heat management systems, there is a risk that an air bubble is mixed (remains) in the flow channel 130a.

Hence, in the embodiment, when the charging of the electrified vehicle 10 is ended in a state where the flow channel 130a and the flow channel 170a are disconnected, the heat management system 1 executes (starts) an air removal process (referred to as an "air removal process A", hereinafter) for the flow channel 130a and the flow channel 170a, after the end of the charging, by connecting the flow channel 130a and the flow channel 170a by the five-way valve 180 and driving the water pump (131, 171). Specifically, the ECU 500 executes the air removal process A, by controlling the five-way valve 180 to form the second communication pattern (see FIG. 5) or the third communication pattern (see FIG. 6) and driving the water pump (131, 171). Thereby, the air removal is performed by the reserve tank 175, in both of the flow channel 130a and the flow channel 170a. The air removal process A is an example of the "air removal process" in the present disclosure.

Further, the above "after the end of the charging" means a time (waiting time) after the charging of the electrified vehicle 10 is ended and before a next operation (for example, traveling, charging, or the like) is started, for example. Here, the above "after the end of the charging" may means a period after the time point when the charging of the electrified vehicle 10 is ended and before the elapse of a predetermined time (for example, five minutes).

### Control Flow by ECU

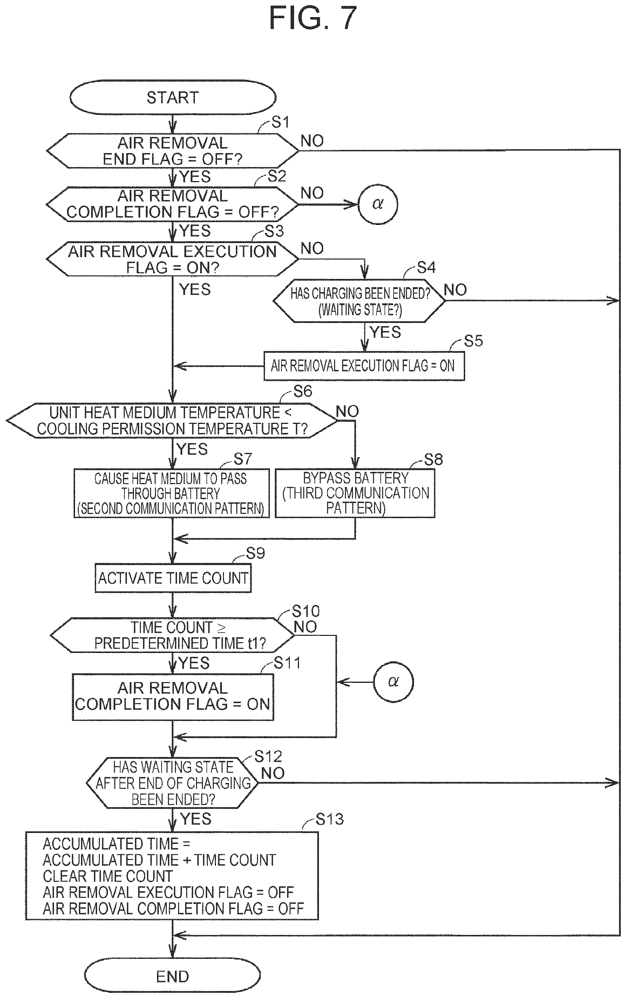

Next, control flows by the ECU 500 (processor 501) will be described with reference to FIG. 7 to FIG. 10. A control flow shown in FIG. 7 may be executed (started) with a predetermined period (for example, one second).

As shown in FIG. 7, in step S1, the ECU 500 determines whether an air removal end flag is in the OFF-state. The air removal end flag, which will be described later in detail, is a flag (signal) that changes based on the length of an accumulated time for which the air removal has been performed in the electrified vehicle 10. In the case where the above accumulated time is a later-described prescribed time t2 or less, it is determined that the air removal is insufficient, and the air removal end flag is maintained in the OFF-state. In the case where the air removal end flag is in the OFF-state (Yes in S1), the process proceeds to step S2. In the case where the air removal end flag is in the ON-state (No in S1), the process ends.

In step S2, the ECU 500 determines whether an air removal completion flag is in the OFF-state. The air removal completion flag is a flag indicating whether the air removal process A during the charging has been completed (finished) once. In the case where the execution time (duration time) for which the air removal process A has been executed once is less than a later-described predetermined time t1, it is determined that the air removal process A has not been completed, and the air removal completion flag is maintained in the OFF-state. In the case where the air removal completion flag is in the OFF-state (Yes in S2), the process proceeds to step S3. In the case where the air removal completion flag is in the ON-state (No in S2), the process proceeds to step S12.

In step S3, the ECU 500 determines whether the air removal execution flag is in the ON-state. In the case where the air removal execution flag is in the ON-state, the air removal process (air removal process A) after the end of the charging of the battery 173 is executed. In the case where the air removal execution flag is in the ON-state (Yes in S3), the process proceeds to step S6. In the case where the air removal execution flag is in the OFF-state (No in S3), the process proceeds to step S4. In the case where the air removal execution flag is in the OFF-state, the first communication pattern (see FIG. 4) is formed in the heat management circuit 100, for example.

In step S4, the ECU 500 determines whether the charging of the battery 173 has been ended. Specifically, the ECU 500 determines whether the electrified vehicle 10 is in a waiting state after the charging of the battery 173 is ended and before a next operation (for example, traveling, charging, or the like) is started. For example, the ECU 500 may determine that the charging has been ended, for example, in the case where the charge connector 21 has been detached from the inlet 12, where State-Of-Charge (SOC) has reached a predetermined value (for example, 100%), where the charge current is zero (the electricity supply from the EVSE 20 is not being performed), or where the electrified vehicle 10 has moved from a charging facility or the like. Further, the ECU 500 may determine that the electrified vehicle 10 is in the waiting state, for example, in the case where the vehicle speed of the electrified vehicle 10 is zero, where the electrified vehicle 10 is in a ready-OFF-state, or where the charge current is zero (the electricity supply from the EVSE 20 is not being performed). In the case where the charging has been ended (and in the case of being in the waiting state) (Yes in S4), the process proceeds to step S5. In the case where the charging has not been ended (or in the case of being not in the waiting state) (No in S4), the process ends.

In step S5, the ECU 500 turns the air removal execution flag ON. Thereby, the ECU 500 starts the air removal process A. Specifically, the ECU 500 controls the five-way valve 180 to form the second communication pattern (see FIG. 5) or the third communication pattern (see FIG. 6), and drives the water pump (131, 171). At the time point of step S5, the second communication pattern may be formed, or the third communication pattern may be formed. Further, the control of the communication pattern by the five-way valve 180 may be suspended until the determination in step S6 described later is completed.

In step S6, the ECU 500 determines whether the temperature of the heat medium that flows through the low-temperature circuit 130 (flow channel 130a) is lower than a cooling permission temperature T. Specifically, the ECU 500 determines whether the detection value of the temperature sensor 136 (see FIG. 2) is lower than the cooling permission temperature T (for example, 40°C) that is previously stored in the memory 502. In the case where the temperature of the heat medium is lower than the cooling permission temperature T (Yes in S6), the process proceeds to step S7. In the case where the temperature of the heat medium is the cooling permission temperature T or higher (No in S6), the process proceeds to step S8. The cooling permission temperature T is an example of the "predetermined temperature" in the present disclosure.

In step S7, for causing the heat medium to pass (flow) through the battery 173 (portion 170b), the ECU 500 controls the five-way valve 180 such that the second communication pattern (see FIG. 5) is formed. Next, the process proceeds to step S9.

In step S8, for causing the heat medium to pass (flow) through the bypass channel 174 without causing the heat medium to pass (flow) through the battery 173 (portion 170b), the ECU 500 controls the five-way valve 180 such that the third communication pattern (see FIG. 6) is formed. Next, the process proceeds to step S9.

In step S9, the ECU 500 activates the time count by the timer 505 (see FIG. 2). In the case where the time count by the timer 505 has been already activated at the time point of step S9, the ECU 500 continues the time count by the timer 505. Next, the process proceeds to step S10.

In step S10, the ECU 500 determines whether the time count by the timer 505 is the predetermined time t1 (for example, 30 seconds to 1 minute) or more. Information about the predetermined time t1 may be previously stored in the memory 502. In the case where the time count is the predetermined time t1 or more (Yes in S10), the process proceeds to step S11. In the case where the time count is less than the predetermined time t1 (No in S10), the process proceeds to step S12. The predetermined time t1 is an example of the "first time" in the present disclosure.

In step S11, the ECU 500 turns the air removal completion flag ON. Next, the process proceeds to step S12.

In step S12, the ECU 500 determines whether the waiting state after the end of the charging of the battery 173 has been ended. The ECU 500 may determine that the waiting state of the electrified vehicle 10 has been ended, for example, in the case where the vehicle speed of the electrified vehicle 10 after the end of the charging is higher than zero, where the electrified vehicle 10 after the end of the charging is in a ready-ON-state, or where the charge current after the end of the charging is higher than zero (the electricity supply from the EVSE 20 is being performed). In the case where the waiting state has been ended (Yes in S12), the process proceeds to step S13. In the case where the waiting state has not been ended (No in S12), the process ends.

In step S13, the ECU 500 stores the total value of the current accumulated time and the time count of the timer 505, in the memory 502 or the like, as an updated accumulated time. The accumulated time is the accumulated value of a time for which the water pump (131, 171) has been driven in the state where the flow channel 170a and the flow channel 130a are connected.

That is, the accumulated time is the total value of a first accumulated time for which the air removal process A has been executed and a second accumulated time for which the water pump (131, 171) has been driven in the state where the flow channel 170a and the flow channel 130a are connected, at a timing other than the timing after the end of the charging. The first accumulated time is the accumulated value of the time count of the timer 505. The second accumulated time will be described later. For example, the timing other than the timing after the end of the charging includes the time of the traveling of the electrified vehicle 10, the time of the charging of the battery 173, the time when an air-conditioner, an audio, or the like is used by the electric power from an external electric power source (the EVSE 20 or the like) in the state where the charge connector 21 is connected to the electrified vehicle 10, and others.

Further, in step S13, the ECU 500 clears the time count of the timer 505. Further, the ECU 500 turns each of the air removal execution flag and the air removal completion flag OFF. Thereby, the air removal process A is stopped (ended). Thereafter, the process ends.

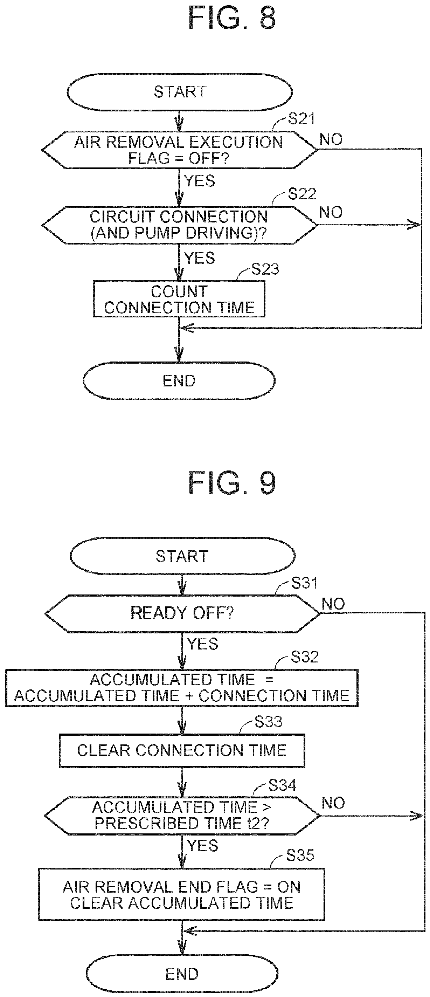

FIG. 8 is a second diagram showing a control flow by the ECU 500 (processor 501) according to the embodiment. The control flow shown in FIG. 8 may be executed (started) with a predetermined period (for example, one second).

In step S21, the ECU 500 determines whether the air removal execution flag is in the OFF-state. That is, the ECU 500 determines whether the air removal process A is not being executed. In the case where the air removal execution flag is in the OFF-state (Yes in S21), the process proceeds to step S22. In the case where the air removal execution flag is in the ON-state (No in S21), the process ends.

In step S22, the ECU 500 determines whether the flow channel 170a and the flow channel 130a are connected and whether the water pump (131 or 171) is being driven. That is, the ECU 500 determines whether the air removal is being executed in each of the flow channel 170a and the flow channel 130a while the air removal process A is not being executed. In the case of Yes in step S22, the process proceeds to step S23. In the case of No in step S22, the process ends.

In step S23, the ECU 500 activates the time count by the timer 506 (see FIG. 2), and thereby, counts a time (referred to as a connection time, hereinafter) for which the water pump (131 or 171) is driven in the state where the flow channel 170a and the flow channel 130a are connected. The counted connection time is stored in the memory 502 or the like. Thereafter, the process ends. The connection time is an example of the above second accumulated time.

FIG. 9 is a third diagram showing a control flow by the ECU 500 according to the embodiment. The control flow shown in FIG. 9 may be executed (started) with a predetermined period (for example, one second).

In step S31, the ECU 500 determines whether the electrified vehicle 10 is in the ready-OFF-state (in the state where the traveling is impossible). More specifically, the ECU 500 determines whether the electrified vehicle 10 is in the ready-OFF-state and an ignition power source is in the ON-state (IGON) (system startup). In the case where the electrified vehicle 10 is in the ready-OFF-state (Yes in S31), the process proceeds to step S32. In the case where the electrified vehicle 10 is in the ready-ON-state (No in S31), the process ends.

In step S32, the ECU 500 stores the total value of the current accumulated time and the connection time (see S23 in FIG. 8), in the memory 502 or the like, as an updated accumulated time.

In step S33, the ECU 500 clears information about the connection time. Specifically, the ECU 500 erases the information about the connection time, from the memory 502 or the like.

In step S34, the ECU 500 determines whether the accumulated time calculated in step S32 has exceeded the prescribed time t2 (for example, 80 hours). That is, the ECU 500 determines whether the accumulated time for which the water pump (131 or 171) has been driven in the state where the flow channel 130a and the flow channel 170a are connected has exceeded the prescribed time t2. In the case where the accumulated time has exceeded the prescribed time t2 (Yes in S34), the process proceeds to step S35. In the case where the accumulated time is the prescribed time t2 or less (No in S34), the process ends. The prescribed time t2 is an example of the "second time" in the present disclosure.

In step S35, the ECU 500 turns the air removal end flag ON. That is, as seen from step S1 in FIG. 7, in the heat management system 1, the air removal process A is not executed (the execution is restricted), after the air removal end flag is turned ON. Further, the ECU 500 clears information about the accumulated time calculated in step S32. Specifically, the ECU 500 erases the information about the accumulated time, from the memory 502 or the like.

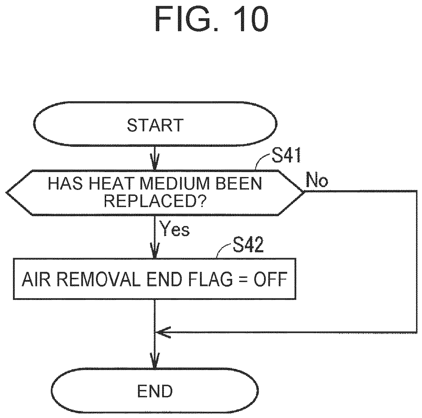

FIG. 10 is a fourth diagram showing a control flow by the ECU 500 according to the embodiment. The control flow shown in FIG. 10 may be executed (started) with a predetermined period (for example, one second).

In step S41, the ECU 500 determines whether the heat medium that flows through the electrified vehicle 10 (heat management circuit 100) has been replaced. For example, the ECU 500 may determine whether the heat medium has been replaced, based on information (information indicating that the replacement of the heat medium has been completed) that is input to the electrified vehicle 10 when the heat medium has been replaced in a dealer or the like. In the case where the heat medium has been replaced (Yes in S41), the process proceeds to step S42. In the case where the heat medium has not been replaced (No in S41), the process ends.

In step S42, the ECU 500 turns the air removal end flag OFF. Thereby, as seen from step S1 in FIG. 7, after the air removal end flag is turned OFF, the heat management system 1 is in a state where the air removal process A can be executed. Thereafter, the process ends.

As described above, in the embodiment, when the charging of the electrified vehicle 10 is ended in the state where the flow channel 130a and the flow channel 170a are disconnected, the heat management system 1 executes the air removal process A for the flow channel 130a and the flow channel 170a, after the end of the above charging, by connecting the flow channel 130a and the flow channel 170a by the five-way valve 180 and driving the water pump (131, 171). Thereby, it is possible to restrain the air bubble from being mixed (remaining) in each of the flow channel 130a and the flow channel 170a. As a result, it is possible to efficiently cool the battery 173, the PCU 133, and the like. Further, it is possible to restrain the water pump (131, 171) from being driven in a state where the air bubble is mixed (remains), and thereby, it is possible to reduce the load on the water pump (131, 171). Further, by performing the air removal during the waiting time after the end of the charging, it is possible to remove the air bubble by the air removal before the drive (for example, traveling) of the electrified vehicle 10. As a result, it is possible to efficiently cool the battery 173, the PCU 133, and the like, at the time of the drive of the electrified vehicle 10, that is, at the time when the amount of heat generation is relatively large.

### Modifications of Heat Management System

In the above embodiment, the example in which the communication pattern of the heat management circuit 100 is controlled by the five-way valve 180 has been shown, but the present disclosure is not limited to this. A switching valve other than the five-way valve 180 may be used.

### First Modification

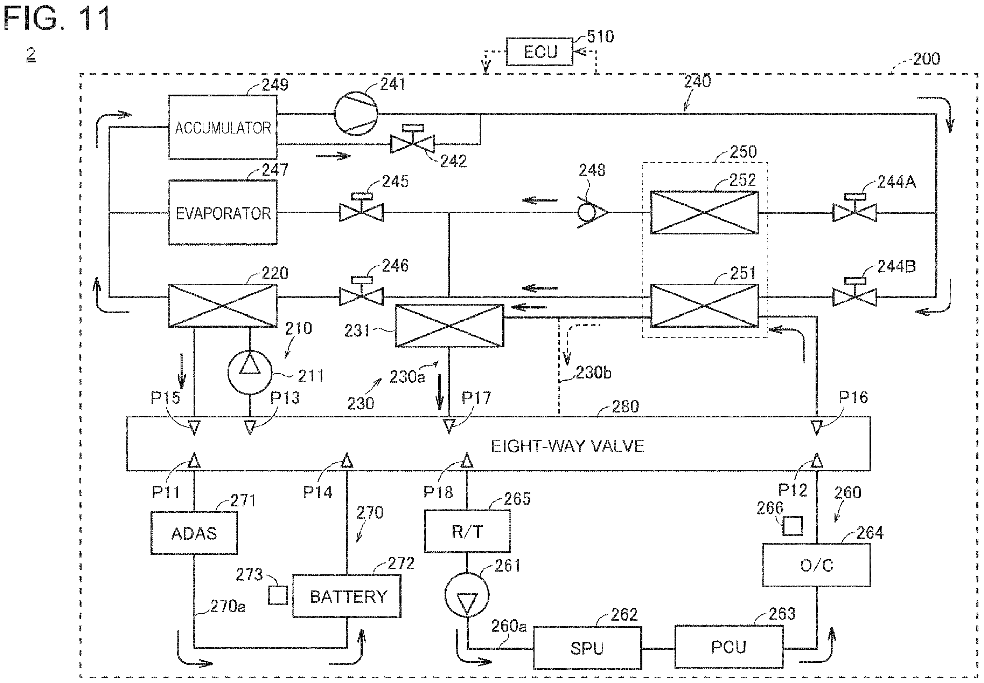

FIG. 11 is a diagram showing an example of the overall configuration of a heat management system 2 (heat management circuit 200) that is a first modification of the above embodiment.

The heat management system 2 includes a heat management circuit 200. For example, the heat management circuit 200 includes a chiller circuit 210, a chiller 220, a radiator circuit 230, a refrigeration cycle 240, a condenser 250, a drive unit circuit 260, a battery circuit 270, and an eight-way valve 280. The heat management circuit 200 is controlled by an ECU 510. Further, the eight-way valve 280 is an example of the "switching device" in the present disclosure.

The chiller circuit 210 includes a water pump (W/P) 211. The chiller 220 is connected to (shared by) both of the chiller circuit 210 and the refrigeration cycle 240.

The radiator circuit 230 includes a radiator 231. For example, the refrigeration cycle 240 includes a compressor 241, a solenoid valve 242, solenoid valves 244A, 244B, 245, 246, an evaporator 247, a check valve 248, and an accumulator 249. The condenser 250 includes a water-cooling condenser 251 and an air-cooling condenser 252. The water-cooling condenser 251 is connected to both of the refrigeration cycle 240 and the radiator circuit 230.

For example, the drive unit circuit 260 includes a water pump 261, a SPU 262, a PCU 263, an oil cooler 264, a reserve tank 265, and a heat medium temperature sensor 266. Instead of the oil cooler 264, a transaxle may be provided in the drive unit circuit 260. Further, an e-axle may be provided by integrating the PCU 263 and the oil cooler 264 (or the transaxle). The PCU 263 and the oil cooler 264 constitute a device that can generate the drive power that is supplied to the electrified vehicle. Each of the PCU 263 and the oil cooler 264 is an example of the "first drive device" in the present disclosure. Further, the water pump 261 is an example of the "pump" in the present disclosure.

For example, the battery circuit 270 includes an advanced driver-assistance system (ADAS) 271, a battery 272, and a temperature sensor 273. The battery 272 is an example of the "first electric storage device" in the present disclosure.

The eight-way valve 280 includes eight ports P11 to P18. The eight-way valve 280 is connected to the chiller circuit 210, the radiator circuit 230, the drive unit circuit 260, and the battery circuit 270.

The heat medium that circulates through the chiller circuit 210 flows through a channel that passes through the eight-way valve (port P13), the water pump 211, the chiller 220, and the eight-way valve 280 (port P15).

The water pump 211 causes the heat medium to circulate through the chiller circuit 210, in accordance with the control command from the ECU 510. The chiller 220 performs heat exchange between the heat medium that circulates through the chiller circuit 210 and the heat medium that circulates through the refrigeration cycle 240. The eight-way valve 280 switches a channel to which the chiller circuit 210 is connected, in accordance with the control command from the ECU 510. The switching of the channel by the eight-way valve 280 will be described later in detail.

The heat medium that circulates through the radiator circuit 230 flows through a first channel that passes through the eight-way valve 280 (port P16), the water-cooling condenser 251, the radiator 231, and the eight-way valve 280 (port P17), or a second channel that passes through the eight-way valve 280 (port P16), the water-cooling condenser 251, a bypass channel 230b, and the eight-way valve 280 (port P17). The switching between the first channel and the second channel can be performed by the rotation of the eight-way valve 280. The radiator 231 is disposed downstream of a grill shutter (not illustrated), and performs heat exchange between the air in the exterior of the vehicle and the heat medium.

The heat medium (a gas-phase refrigerant or a liquid-phase refrigerant) that circulates through the refrigeration cycle 240 flows through one of the following first to fourth channels. The first channel is a channel that passes through the compressor 241, the solenoid valve 244A, the air-cooling condenser 252, the check valve 248, the solenoid valve (expansion valve) 245, the evaporator 247, the accumulator 249, and the compressor 241. The second channel is a channel that passes through the compressor 241, the solenoid valve 244A, the air-cooling condenser 252, the check valve 248, the solenoid valve (expansion valve) 246, the chiller 220, the accumulator 249, and the compressor 241. The third channel is a channel that passes through the compressor 241, the solenoid valve 244B, the water-cooling condenser 251, the solenoid valve (expansion valve) 245, the evaporator 247, the accumulator 249, and the compressor 241. The fourth channel is a channel that passes through the compressor 241, the solenoid valve 244B, the water-cooling condenser 251, the solenoid valve 246, the chiller 220, the accumulator 249, and the compressor 241.

The compressor 241 compresses the gas-phase refrigerant that circulates through the refrigeration cycle 240, in accordance with the control command from the ECU 510. The solenoid valve 242 is connected in parallel to the compressor 241, and adjusts the inflow amount of the gas-phase refrigerant to the compressor 241, in accordance with the control command from the ECU 510. The solenoid valve 244 (244A, 244B) switches the flow destination of the gas-phase refrigerant that is discharged from the compressor 241, between the water-cooling condenser 251 and the air-cooling condenser 252, in accordance with the control command from the ECU 510. The water-cooling condenser 251 performs heat exchange between the gas-phase refrigerant that is discharged from the compressor 241 and the heat medium that flows through the radiator circuit 230. The air-cooling condenser 252 performs heat exchange with the air that is introduced into a vehicle cabin, and produces warm air. The solenoid valve 245 restricts the inflow of the liquid-phase refrigerant to the evaporator 247, in accordance with the control command from the ECU 510. The solenoid valve 246 restricts the inflow of the liquid-phase refrigerant to the chiller 220, in accordance with the control command from the ECU 510. The solenoid valves 245, 246 have also a function to expand the liquid-phase refrigerant. The accumulator 249 removes the liquid-phase refrigerant from the refrigerant in a gas-liquid mixed state, and prevents the liquid-phase refrigerant from being sucked in the compressor 241 in the case where the refrigerant is not fully evaporated by the evaporator 247.

The heat medium (coolant) that circulates through the drive unit circuit 260 flows through a channel that passes through the eight-way valve 280 (port P18), the reserve tank 265, the water pump 261, the SPU 262, the PCU 263, the oil cooler 264, and the eight-way valve 280 (port P12).

The water pump 261 causes the heat medium to circulate through the drive unit circuit 260, in accordance with the control command from the ECU 510. The SPU 262 controls the charging and discharging of the battery 272, in accordance with the control command from the ECU 510. The PCU 263 converts direct-current power supplied from the battery 272, into alternating-current power, and supplies the alternating-current power to a motor (not illustrated) built in the transaxle, in accordance with the control command from the ECU 510. The oil cooler 264 cools the transaxle by the heat exchange between the heat medium that circulates through the drive unit circuit 260 and the lubricant for the motor. Heat exchange may be performed between the heat that is generated by supplying electric power to a stator of the motor without rotating a rotor of the motor and the heat medium that circulates through the drive unit circuit 260.

The SPU 262, the PCU 263, and the oil cooler 264 are cooled by the heat medium that circulates through the drive unit circuit 260. The reserve tank 265 retains some (the heat medium that has overflowed due to the increase in pressure) of the heat medium in the drive unit circuit 260, and thereby, maintains the pressure and amount of the heat medium in the drive unit circuit 260.

The heat medium temperature sensor 266 detects the temperature of the heat medium in a later-described flow channel 260a on which the PCU 263 and the like are provided. Specifically, the heat medium temperature sensor 266 detects the temperature of the heat medium that flows between the oil cooler 264 and the eight-way valve 280 (flows through the downstream side of the oil cooler 264). The heat medium temperature sensor 266 may detect the temperature of the heat medium between the PCU 263 and the oil cooler 264, for example.

The heat medium (coolant) that circulates through the battery circuit 270 flows through a channel that passes through the eight-way valve 280 (port P11), the ADAS 271, the battery 272, and the eight-way valve 280 (port P14).

For example, the ADAS 271 includes an adaptive cruise control (ACC), an auto speed limiter (ASL), a lane keeping assist (LKA), a pre-crash safety (PCS), and a lane departure alert (LDA). The battery circuit 270 may include an autonomous driving system (ADS), in addition to the ADAS 271. The battery 272 supplies electric power for driving, to the motor built in the transaxle. The temperature sensor 273 detects the temperature of the battery 272.

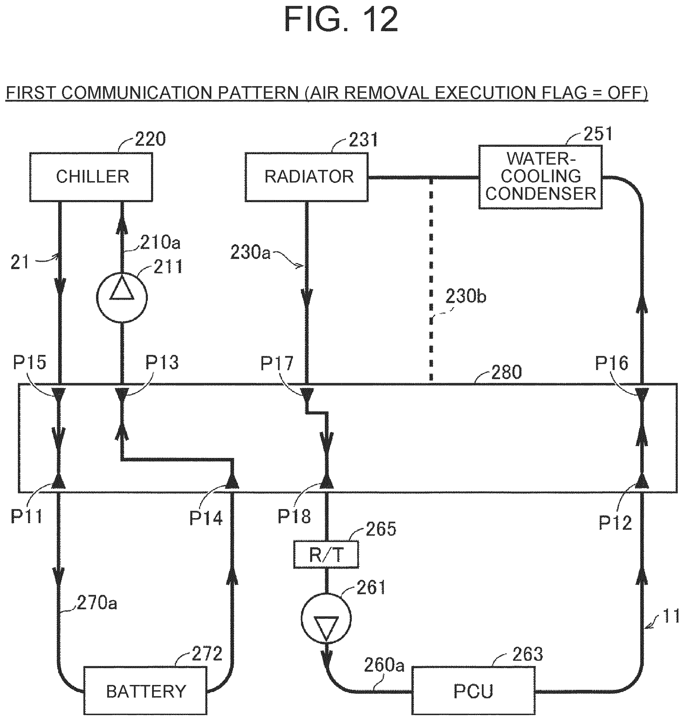

As shown in FIG. 12, the chiller 220 is provided on a flow channel 210a of the chiller circuit 210. The flow channel 210a is a flow channel that connects the port P13 and port P15 of the eight-way valve 280.

The radiator 231 is provided on a flow channel 230a of the radiator circuit 230. Further, the flow channel 230a includes the bypass channel 230b that bypasses the radiator 231. The bypass channel 230b is provided so as to connect a portion between the water-cooling condenser 251 and the radiator 231 and the eight-way valve 280. In the case where the heat medium flows through the bypass channel 230b, the heat medium does not flow through the radiator 231. Further, in the case where the heat medium flows through the radiator 231, the heat medium does not flow through the bypass channel 230b.

The water pump 261, the SPU 262, the PCU 263, the oil cooler 264, and the reserve tank 265 (in FIG. 12, the SPU 262 and the oil cooler 264 are not illustrated) are provided on the flow channel 260a of the drive unit circuit 260. The flow channel 260a is a flow channel that connects the port P18 and port P12 of the eight-way valve 280. The flow channel 260a is an example of the "second flow channel" in the present disclosure.

The battery 272 is provided on a flow channel 270a of the battery circuit 270. The flow channel 270a is a flow channel that connects the port P11 and port P14 of the eight-way valve 280. The flow channel 270a is an example of the "first flow channel" in the present disclosure.

### Communication Pattern

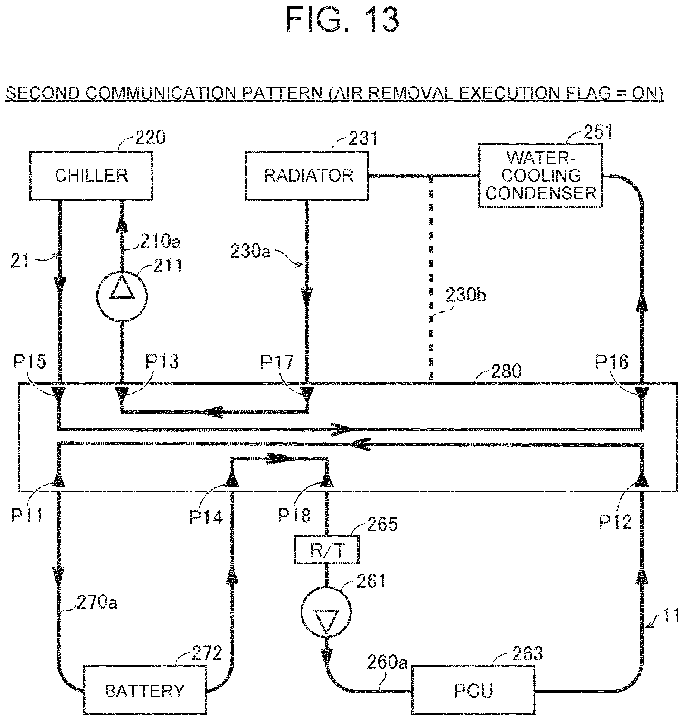

FIG. 12 and FIG. 13 are diagrams showing examples of a first communication pattern and a second communication pattern by the eight-way valve 280, respectively. The first communication pattern and second communication pattern by the eight-way valve 280 are not limited to the examples shown in FIG. 12 and FIG. 13, respectively.

As shown in FIG. 12, in the first communication pattern, a channel that provides communication between the port P11 and the port P15 is formed in the eight-way valve 280. Further, in the first communication pattern, a cannel that provides communication between the port P14 and the port P13 is formed in the eight-way valve 280. Further, in the first communication pattern, a channel that provides communication between the port P17 and the port P18 is formed in the eight-way valve 280. Further, in the first communication pattern, a channel that provides communication between the port P12 and the port P16 is formed in the eight-way valve 280. Further, in the first communication pattern, the radiator 231 and the port P17 of the eight-way valve 280 are connected by the flow channel 230a. As described above, in the first communication pattern, the flow channel 270a and the flow channel 260a are disconnected. The first communication pattern shown in FIG. 12 is a circuit pattern corresponding to the first communication pattern (see FIG. 4) in the above embodiment.

As shown in FIG. 13, in the second communication pattern, a channel that provides communication between the port P11 and the port P12 is formed in the eight-way valve 280. Further, in the second communication pattern, a channel that provides communication between the port P14 and the port P18 is formed in the eight-way valve 280. Further, in the second communication pattern, a channel that provides communication between the port P13 and the port p17 is formed in the eight-way valve 280. Further, in the second communication pattern, a channel that provides communication between the port P15 and the port P16 is formed in the eight-way valve 280. Further, in the second communication pattern, the radiator 231 and the port P17 of the eight-way valve 280 are connected by the flow channel 230a. As described above, in the second communication pattern, the flow channel 270a and the flow channel 260a are connected. That is, the second communication pattern shown in FIG. 13 is a circuit pattern corresponding to the second communication pattern (see FIG. 5) in the above embodiment.

Similarly to the heat management system 1 in the above embodiment, when the charging of the electrified vehicle (not illustrated) is ended in the state where the flow channel 270a and the flow channel 260a are disconnected (see FIG. 12), the heat management system 2 executes the air removal process A for the flow channel 270a and the flow channel 260a, after the end of the above charging, by connecting the flow channel 270a and the flow channel 260a by the eight-way valve 280 and driving the water pump 261. The control flows in the above embodiment may be applied as control flows for the air removal process in the first modification.

### Modified Examples in First Modification

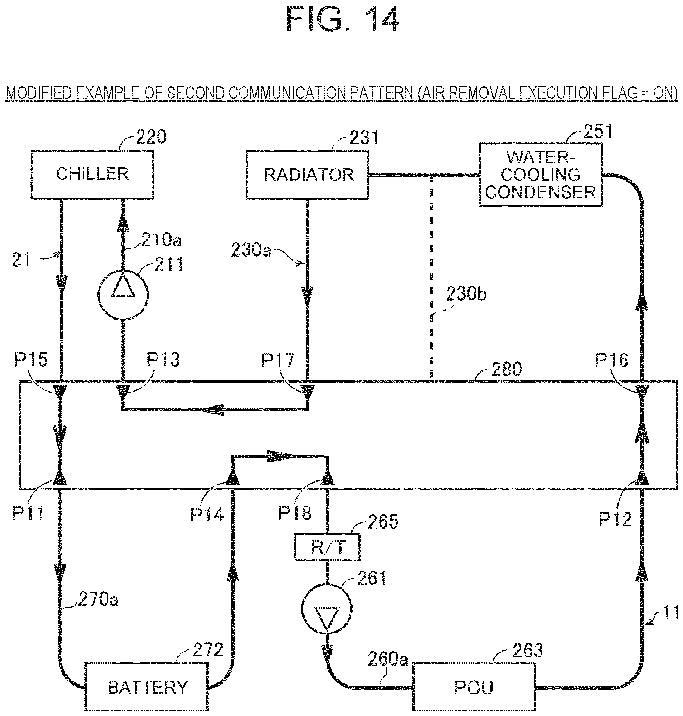

In the above first modification, the example in which the flow channel 270a and the flow channel 260a are connected in the second communication pattern has been shown, but the present disclosure is not limited to this. As shown in FIG. 14, as the second communication pattern, the flow channel 270a, the flow channel 260a, the flow channel 230a (or the bypass channel 230b), and the flow channel 210a may be connected.

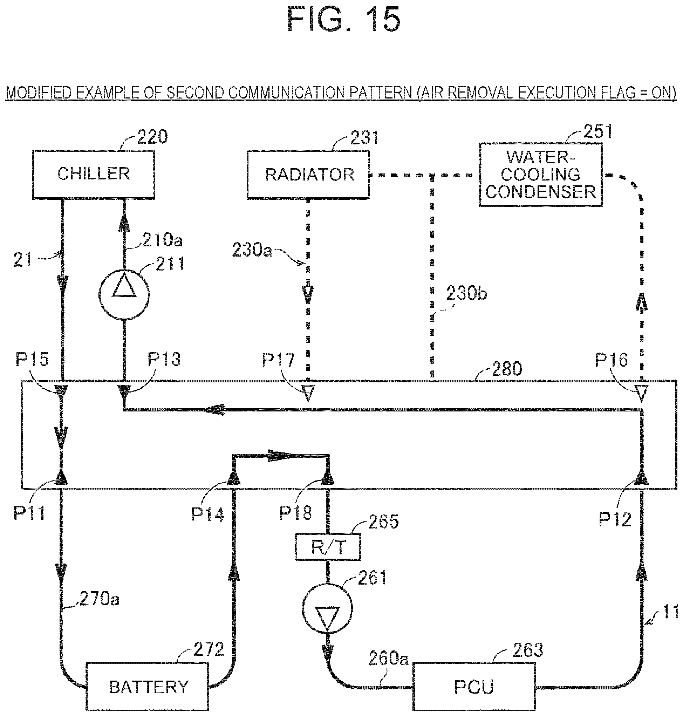

Further, as shown in FIG. 15, as the second communication pattern, the flow channel 270a, the flow channel 260a, and the flow channel 210a may be connected. In this case, the flow channel 230a (and the bypass channel 230b) is disconnected from the other flow channels. Although not illustrated, as the second communication pattern, the flow channel 270a, the flow channel 260a, and the flow channel 230a (or the bypass channel 230b) may be connected, and the flow channel 210a may be disconnected from the other flow channels.

The combination of the first communication pattern and the second communication pattern is not limited to the above examples. For example, the first communication pattern may be the circuit shown in FIG. 13 or FIG. 15, and the second communication pattern may be the circuit shown in FIG. 14. Further, the first communication pattern may be the circuit shown in FIG. 13, and the second communication pattern may be the circuit shown in FIG. 14 or FIG. 15.

### Second Modification

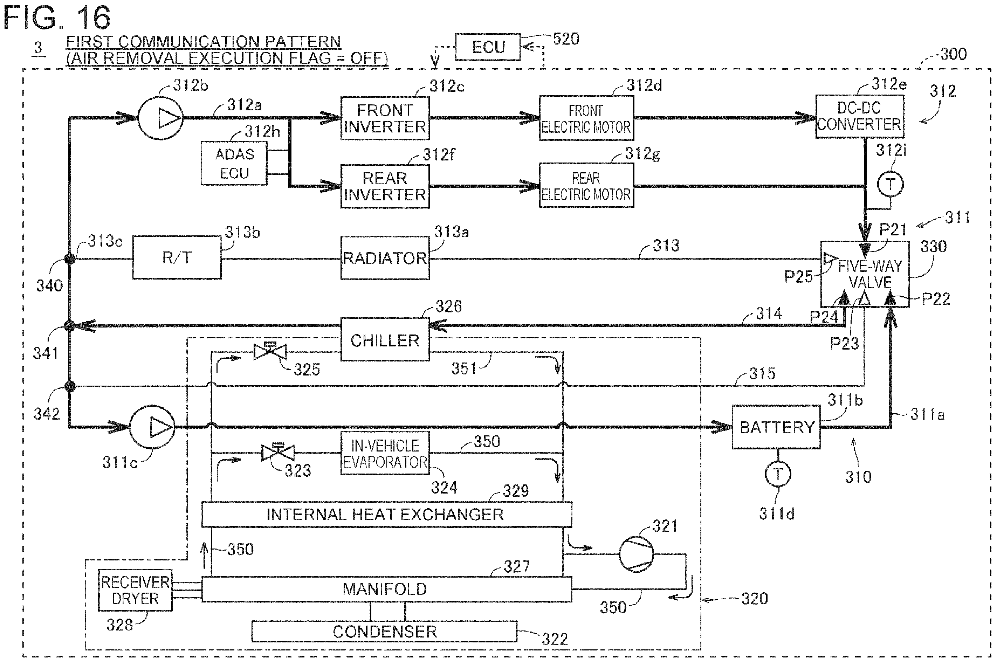

FIG. 16 is a diagram showing an example of the overall configuration of a heat management system 3 (heat management circuit 300) that is a second modification of the above embodiment.

The heat management circuit 300 includes a heat medium circuit 310 that includes a heat medium (water or the like) and a refrigeration circuit 320 that includes a working medium (water, a medium having a lower boiling point than water, or the like). First, the refrigeration circuit 320 will be described below.

The refrigeration circuit 320 includes a compression machine 321, a condenser 322, a first expansion valve 323, an in-vehicle evaporator 324, a second expansion valve 325, a chiller 326, a circulation flow channel 350, and an in-vehicle evaporator bypass flow channel 351.

The compression machine 321 compresses the working medium. The condenser 322 condenses the working medium that is discharged from the compression machine. The first expansion valve 323 expands the working medium that flows from the condenser 322. The in-vehicle evaporator 324 performs heat exchange between the working medium that flows from the first expansion valve 323 and the air in the interior of the vehicle (in the vehicle cabin of the vehicle).

The circulation flow channel 350 is a flow channel through which the working medium circulates. The circulation flow channel 350 connects the compression machine 321, the condenser 322, the first expansion valve 323, and the in-vehicle evaporator 324, in this order.

The in-vehicle evaporator bypass flow channel 351 is connected to the circulation flow channel 350, so as to bypass the in-vehicle evaporator 324. The second expansion valve 325 is provided on the in-vehicle evaporator bypass flow channel 351.

The refrigeration circuit 320 further includes a manifold 327, a receiver dryer 328, and an internal heat exchanger 329.

The manifold 327 is provided on the circulation flow channel 350. The receiver dryer 328 is connected to the manifold 327. The internal heat exchanger 329 is connected to a site that is of the circulation flow channel 350 and that is on the upstream side of the first expansion valve 323 and a site that is of the circulation flow channel 350 and that is on the downstream side of the in-vehicle evaporator 324.

Next, the heat medium circuit 310 will be described. The heat medium circuit 310 includes a first circuit 311, a second circuit 312, a flow channel 313, a radiator 313a, a reserve tank 313b, a flow channel 314, a chiller 326, a flow channel 315, and a five-way valve 330. The five-way valve 330 includes ports P21 to P25. The five-way valve 330 is an example of the "switching device" in the present disclosure.

The first circuit 311 includes a flow channel 311a, a battery 311b, a water pump 311c, and a temperature sensor 311d. The first circuit 311 is a circuit that is formed by the flow channel 311a and one of the flow channels 313 to 315. The water pump 311c and the battery 311b are examples of the "pump" and "second electric storage device" in the present disclosure, respectively. Further, the flow channel 311a is an example of the "first flow channel" in the present disclosure.

The flow channel 311a is a flow channel through which the heat medium flows. The flow channel 311a is a flow channel that couples the water pump 311c and the port P22 of the five-way valve 330. The battery 311b is connected to the flow channel 311a, so as to perform heat exchange with the heat medium that flows through the flow channel 311a. That is, the battery 311b thermally contacts with the flow channel 311a. The water pump 311c is provided on the flow channel 311a. The temperature sensor 311d detects the temperature of the battery 311b.

The second circuit 312 includes a flow channel 312a, a water pump 312b, a drive device, and a temperature sensor 312i. The second circuit 312 is a circuit that is formed by the flow channel 312a and one of the flow channels 313 to 315. The water pump 312b and the flow channel 312a are examples of the "pump" and "first flow channel" in the present disclosure, respectively.

The flow channel 312a is a flow channel through which the heat medium flows. The flow channel 312a is a flow channel that couples the water pump 312b and the port P21 of the five-way valve 330. The water pump 312b is provided on the flow channel 312a.

The drive device is a device that can generate the drive power that is supplied to the electrified vehicle. The drive device is connected to the flow channel 312a, so as to perform heat exchange with the heat medium that flows through the flow channel 312a. That is, the drive device thermally contacts with the flow channel 312a. The drive device is connected to a site that is of the flow channel 312a and that is on the downstream side of the water pump 312b. The drive device includes a front inverter 312c, a front electric motor 312d, a DC-DC converter 312e, a rear inverter 312f, and a rear electric motor 312g. An advanced driver assistance system (ADAS)-electronic control unit (ECU) 312h is connected to the flow channel 312a. The above drive device is an example of the "second drive device" in the present disclosure.

The temperature sensor 312i detects the temperature of the heat medium that flows through the second circuit 312 (flow channel 312a). Specifically, the temperature sensor 312i detects the temperature of the heat medium immediately after the heat medium flows through the drive device (immediately before the heat medium flows into the five-way valve 330).

The flow channel 313 is a flow channel through which the heat medium flows. The radiator 313a and the reserve tank 313b are provided on the flow channel 313. The flow channel 313 is an example of the "second flow channel" in the present disclosure.

The flow channel 314 is a flow channel through which the heat medium flows. The chiller 326 is connected to the flow channel 314 and the in-vehicle evaporator bypass flow channel 351. The chiller 326 performs heat exchange between the heat medium that flows through the flow channel 314 and the working medium that flows through the in-vehicle evaporator bypass flow channel 351.

The five-way valve 330 can switch the connection state of the flow channel 311a, the flow channel 312a, the flow channel 313, the flow channel 314, and the flow channel 315.

As shown in FIG. 16, one end portion of the flow channel 311a is connected to the port P22 of the five-way valve 330. The heat medium that has flowed through the flow channel 311a flows into the five-way valve 330 from the port P22. The other end portion of the flow channel 311a is connected to the water pump 311c.

One end portion of the flow channel 312a is connected to the port P21 of the five-way valve 330. The heat medium that has flowed through the flow channel 312a flows into the five-way valve 330 from the port P21. The other end portion of the flow channel 312a is connected to the water pump 312b.

One end portion of the flow channel 313 is connected to the port P25 of the five-way valve 330. The heat medium that has flowed from the port P25 flows through the flow channel 313. The other end portion 313c of the flow channel 313 is connected to a bifurcation portion 340.

One end portion of the flow channel 314 is connected to the port P24 of the five-way valve 330. The heat medium that has flowed from the port P24 flows through the flow channel 314. The other end portion of the flow channel 314 is connected to a bifurcation portion 341.

One end portion of the flow channel 315 is connected to the port P23 of the five-way valve 330. The heat medium that has flowed from the port P23 flows through the flow channel 315. The other end portion of the flow channel 315 is connected to a bifurcation portion 342. The bifurcation portion 341 is provided between the bifurcation portion 340 and the bifurcation portion 342.

As described above, the flow channel 311a and the flow channel 312a are connected to the five-way valve 330, so as to be parallel to each other

The five-way valve 330 can switch the heat management circuit 300 to a heating mode in which the battery 311b is heated, a cooling mode in which the battery 311b is cooled, an in-vehicle air-cooling mode, an in-vehicle air-heating mode, or a mode in which the modes are combined. The five-way valve 330 is switched by the ECU 520.

FIG. 16 shows an example of a first communication pattern of the heat management circuit 300. In the first communication pattern, the ports P21, P22, P24 are opened, and the ports P23, P25 are closed. Each of the water pumps 311c, 312b is driven.

In the first communication pattern, the heat medium that has flowed from the port P24 of the five-way valve 330 to the flow channel 314 bifurcates at the bifurcation portion 341, and flows toward each of the flow channel 311a and the flow channel 312a. The heat medium pressurized by the water pump 312b performs heat exchange with the drive device, and thereafter, flows into the port P21 of the five-way valve 330. The heat medium pressurized by the water pump 311c performs heat exchange with the battery 311b, and thereafter, flows into the port P22 of the five-way valve 330. In the first communication pattern, the heat medium does not pass through the reserve tank 313b, and therefore, the air removal is not performed in each of the flow channel 311a and the flow channel 312a.

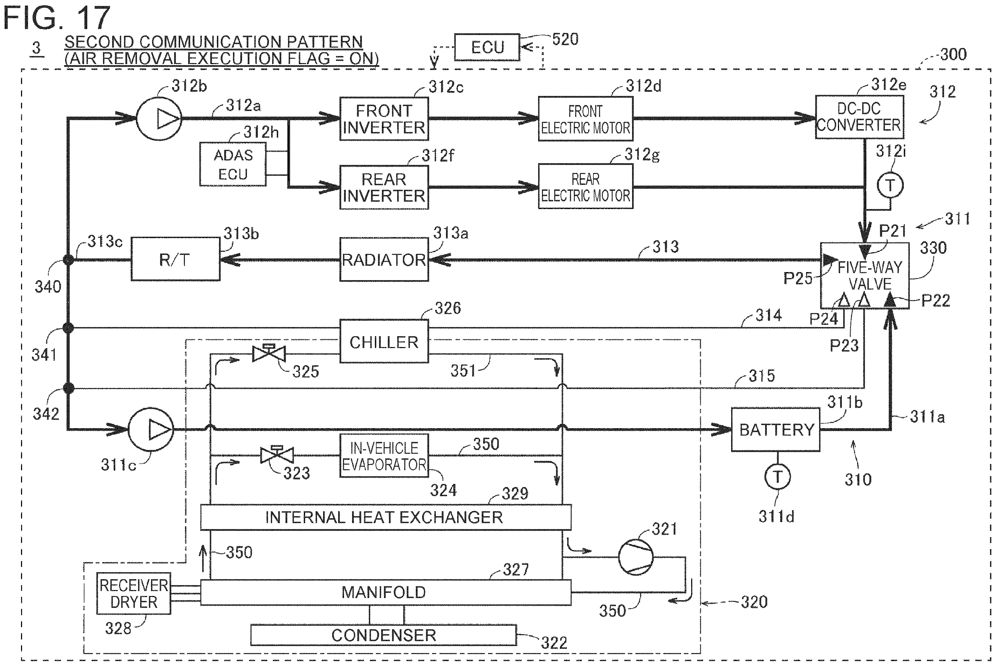

FIG. 17 shows an example of a second communication pattern of the heat management circuit 300. In the second communication pattern, the ports P21, P22, P25 are opened, and the ports P23, P24 are closed. Each of the water pumps 311c, 312b is driven.

The heat medium that has flowed from the port P25 of the five-way valve 330 to the flow channel 313 passes through the reserve tank 313b, bifurcates at the bifurcation portion 340, and flows toward each of the flow channel 311a and the flow channel 312a. Thereby, the air removal is performed by the reserve tank 313b, in each of the flow channel 311a and the flow channel 312a.

Similarly to the above embodiment, when the charging of the electrified vehicle (not illustrated) is ended in the state where the flow channel 311a, the flow channel 312a, and the flow channel 313 are disconnected (see FIG. 16), the heat management system 3 executes the air removal process for the flow channel 311a, the flow channel 312a, and the flow channel 313, after the end of the above charging, by connecting the flow channel 311a, the flow channel 312a, and the flow channel 313 by the five-way valve 330 (see FIG. 17) and driving the water pump (311c, 312b). The control flows in the above embodiment may be applied as control flows for the air removal process in the second modification.

### Modified Examples in Second Modification

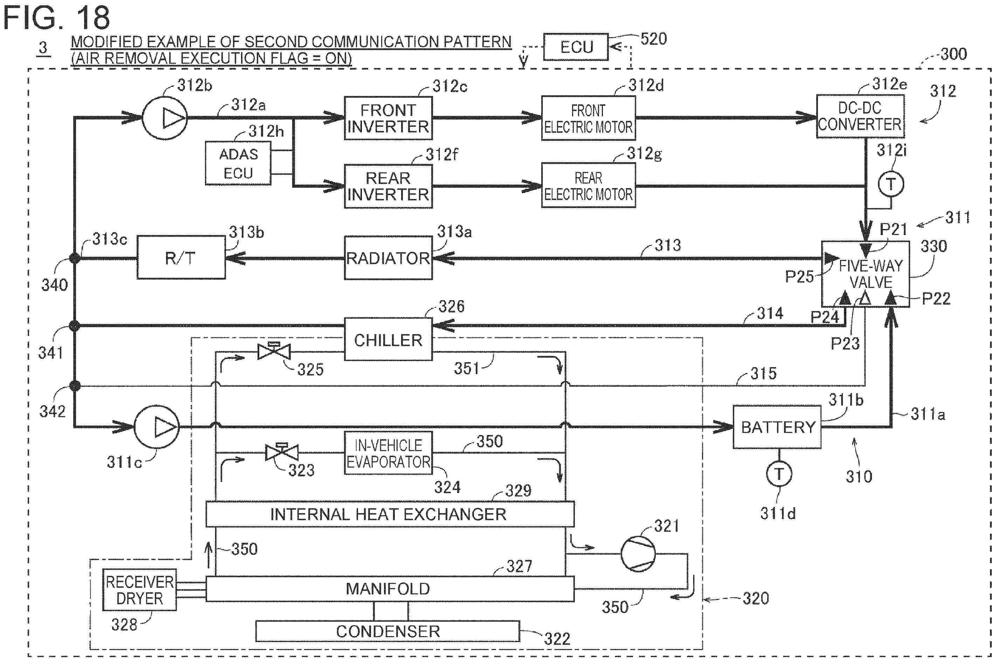

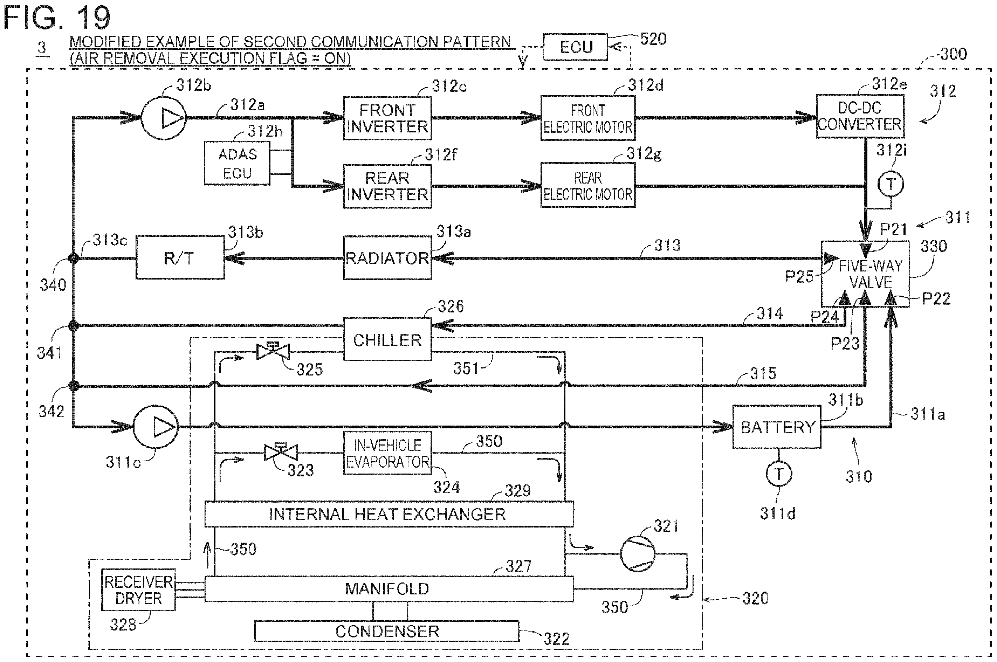

In the above second modification, the example in which the flow channel 311a, the flow channel 312a, and the flow channel 313 are connected in the second communication pattern has been shown, but the present disclosure is not limited to this. For example, as shown in FIG. 18, as the second communication pattern, the flow channel 311a, the flow channel 312a, the flow channel 313, and the flow channel 314 may be connected. Further, as shown in FIG. 19, as the second communication pattern, the flow channel 311a, the flow channel 312a, the flow channel 313, the flow channel 314, and the flow channel 315 may be connected.

Although not illustrated, as the second communication pattern, one or two of the flow channel 311a, the flow channel 312a, the flow channel 314 and the flow channel 315, and the flow channel 313 may be connected.

The combination of the first communication pattern and the second communication pattern is not limited to the above example. For example, the first communication pattern may be the circuit shown in FIG. 17, and the second communication pattern may be the circuit shown in FIG. 18 or FIG. 19. Further, the first communication pattern may be the circuit shown in FIG. 18, and the second communication pattern may be the circuit shown in FIG. 19.

Further, in the heat management circuits in the first modification and the second modification, the bypass channel that bypasses the battery may be provided similarly to the above embodiment.

### Other Modifications

In the above embodiment, the example in which the heat management system 1 is equipped in the electrified vehicle 10 has been shown, but the present disclosure is not limited to this. The heat management system may be equipped in an electric apparatus (for example, a stationary electric storage device) other than the electrified vehicle.

In the above embodiment, the example in which the flowing channel of the heat medium is switched by the five-way valve 180 has been shown, but the present disclosure is not limited to this. For example, the flowing channel of the heat medium may be switched by a six-way valve or a ten-way valve. Further, a plurality of switching valves may be provided.

In the above embodiment, the example in which the reserve tank 175 is disposed on the flow channel 170a on which the battery 173 is provided has been shown, but the present disclosure is not limited to this. Instead of disposing the reserve tank on the flow channel 170a, the reserve tank may be disposed on the flow channel 130a on which the drive device (the PCU 133 and the like) is provided.

In the above embodiment, the example in which the air removal process A is executed by connecting the flow channel 170a on which the battery 173 is provided and the flow channel 130a on which the drive device (the PCU 133 and the like) is provided after the end of the charging of the battery 173 has been shown, but the present disclosure is not limited to this. The air removal process may be executed by connecting flow channels other than the above two flow channels, after the end of the charging of the battery 173.

In the above embodiment, the example in which the bypass channel 174 that bypasses the battery 173 is provided in the heat management circuit 100 has been shown, but the present disclosure is not limited to this. The bypass channel 174 that bypasses the battery 173 may be excluded from the heat management circuit. In this case, the processes of steps S6 to S8 in FIG. 7 do not need to be executed.

In the above embodiment, the example in which the air removal process A is not executed when the accumulated time for which the air removal process has been performed has exceeded the prescribed time t2 (upper limit) has been shown, but the present disclosure is not limited to this. No upper limit may be set for the accumulated time for which the air removal has been performed.

In the above embodiment, the example in which the accumulated time for which the air removal process has been performed is the total time of the accumulated time after the end of the charging and the accumulated time at the timing other than the timing after the end of the charging has been shown, but the present disclosure is not limited to this. For example, the accumulated time for which the air removal process has been performed may include only the accumulated time after the end of the charging.

In the above embodiment, the example in which the water pump is provided in each of the flow channel 170a and the flow channel 130a has been shown, but the present disclosure is not limited to this. The water pump may be provided on only one of the flow channel 170a and the flow channel 130a.

In the above embodiment, the example in which the ECU 500 includes two timers and the two timers measure different times from each other has been shown, but the present disclosure is not limited to this. The ECU may include only one timer.

In the above embodiment, the example in which the temperature sensor 176 that detects the temperature of the battery 173 is provided has been shown, but the present disclosure is not limited to this. The temperature sensor that detects the temperature of the battery 173 may be excluded.

The configurations (processes) in the above embodiment and the above modifications may be combined with each other.

The embodiment and modifications disclosed herein are examples and are not limitative in all respects. It is intended that the scope of the present disclosure is shown not by the above description of the embodiment and the modifications but by the claims and includes all alterations within meanings and ranges that are equivalent to the claims.

## Claims

1. A heat management system provided in an electric apparatus that is able to be charged, the heat management system comprising:
a first flow channel (130a; 270a; 311a; 312a) through which a heat medium flows;
a second flow channel (170a; 260a; 313) through which the heat medium flows and on which a reserve tank (175; 265; 313b) is provided;
a switching device (180; 280; 330) that is able to switch a connection state between the first flow channel (130a; 270a; 311a; 312a) and the second flow channel (170a; 260a; 313); and
a pump (131; 171; 261; 311c; 312b) that causes the heat medium to circulate through each of the first flow channel (130a; 270a; 311a; 312a) and the second flow channel (170a; 260a; 313) in a state where the first flow channel (130a; 270a; 311a; 312a) and the second flow channel (170a; 260a; 313) are connected, wherein
when charging of the electric apparatus is ended in a state where the first flow channel (130a; 270a; 311a; 312a) and the second flow channel (170a; 260a; 313) are disconnected, an air removal process for the first flow channel (130a; 270a; 311a; 312a) and the second flow channel (170a; 260a; 313) executed after the end of the charging, by connecting the first flow channel (130a; 270a; 311a; 312a) and the second flow channel (170a; 260a; 313) by the switching device (180; 280; 330) and driving the pump (131; 171; 261; 311c; 312b).

2. The heat management system according to claim 1, wherein when the air removal process has been continued for a first time or more, the air removal process is ended.

3. The heat management system according to claim 1 or 2, further comprising:
a first electric storage device (173; 272) that performs heat exchange with the heat medium that flows through one of the first flow channel (130a; 270a; 311a; 312a) and the second flow channel (170a; 260a; 313); and
a first drive device (133; 134; 263; 264) that performs heat exchange with the heat medium that flows through the other of the first flow channel (130a; 270a; 311a; 312a) and the second flow channel (170a; 260a; 313), the first drive device (133; 134; 263; 264) being able to generate drive power.

4. The heat management system according to claim 3, further comprising a bypass channel (174) that bypasses at least a portion that is of the first flow channel (130a; 270a; 311a; 312a) and where the heat exchange between the first electric storage device (173; 272) and the heat medium is performed, wherein
when a temperature of the heat medium that flows through the second flow channel (170a; 260a; 313) is a predetermined temperature or higher at a time of the execution of the air removal process, the heat medium does not flow through the portion and flows through the bypass channel (174).

5. The heat management system according to claim 1 or 2, wherein when an accumulated time for which the pump (131; 171; 261; 311c; 312b) has been driven in the state where the first flow channel (130a; 270a; 311a; 312a) and the second flow channel (170a; 260a; 313) are connected has exceeded a second time, the air removal process is not executed.

6. The heat management system according to claim 5, wherein the accumulated time is a total value of a first accumulated time and a second accumulated time, the first accumulated time being an accumulated time for which the air removal process has been executed, the second accumulated time being an accumulated time for which the pump (131; 171; 261; 311c; 312b) has been driven in the state where the first flow channel (130a; 270a; 311a; 312a) and the second flow channel (170a; 260a; 313) are connected, at a timing other than a timing after the end of the charging.

7. The heat management system according to claim 1 or 2, wherein when the heat medium that flows through the electric apparatus has been replaced in a state where the air removal process is not executed, a state where the air removal process is able to be executed is caused.

8. The heat management system according to claim 1 or 2, wherein the switching device (180; 280; 330) includes a five-way valve or an eight-way valve.

9. The heat management system according to claim 1 or 2, further comprising:
a radiator (313a);
a second electric storage device (311b); and
a second drive device (312c, 312d, 312e, 312f, 312g) that is able to generate drive power, wherein:
the radiator (313a) is provided on the second flow channel (170a; 260a; 313); and
at least one of the second electric storage device (311b) and the second drive device (312c, 312d, 312e, 312f, 312g) performs heat exchange with the heat medium that flows through the first flow channel (130a; 270a; 311a; 312a).
